# EUROPEAN PATENT APPLICATION

(11) **EP 0 825 277 A2**
(43) Date of publication of application: **25.02.1998**
(21) Application number: 97113403.6
(22) Date of filing: 04.08.1997
(51) Int. Cl.: C23C 14/35, H01J 37/34

(54) **Optimized magnetic field sputtering**

(30) Priority: 19.08.1996 US 697108
(71) Applicant: TRW INC., Redondo Beach, CA 90278 (US)
(72) Inventor: Roth, James A., Redondo Beach, CA 90277 (US); Bruno, William M., Downey, CA 90241 (US)
(74) Representative: Schmidt, Steffen J., Dipl.-Ing.

(57) **Abstract**

A magnetron sputter deposition system including one or more electromagnets used to define a magnetic field that traps an electron cloud around a sputter target within an evacuated chamber. The electromagnets are positioned within a metal casing of a sputter gun associated with the sputtering system. A cylindrical center north pole piece is positioned within a first electromagnetic coil, where the north pole piece is removable. A second electromagnetic coil is wrapped around a cylindrical pole piece spaced apart from the first electromagnetic coil. A third outside electromagnetic coil is wrapped around a cylindrical south pole piece that is spaced apart from the second electromagnetic coil. By controlling the voltage potential applied to each of the three electromagnetic coils, and inserting or removing the center pole piece, the magnetic field around the target can be manipulated.

## Description

### BACKGROUND OF THE INVENTION

### 1. Field Of The Invention

This invention relates generally to a method and apparatus for sputtering a coating onto a substrate, and more particularly, to a method and apparatus for sputtering a coating onto a smooth substrate in which electromagnets are used to develop controllable magnetic fields to enhance the sputtering parameters in order to provide a smoother coating.

### 2. Discussion of the Related Art

It is necessary that certain high precision components, such as some optical components, have a very smooth surface for increasing or enhancing their desired purpose. For example, it is necessary that mirrors used in many different types of high precision optical apparatuses be very smooth, even on an atomic level, so as to reduce the amount of scattering of light from the mirror, and thus reduce the amount of light intensity that is lost from the reflection of the light off of the mirror. Smooth surfaces for mirrors can be created by applying a reflective material, such as aluminum, to a smooth substrate, such as glass or a high grade plastic.

Different techniques are known in the art that are used to apply a reflective coating to a smooth substrate. One well known technique is the use of sputtering to develop the coating. Magnetron sputter deposition is a thin film deposition process that is more aptly described as a plasma assisted physical vapor deposition process. A sputter target or cathode is used as a source for the desired material to be deposited onto a substrate, and can be, in one example, an aluminum block. A sputter gun, the sputter target, and the substrate are positioned within a chamber that is evacuated. A partial pressure of gas atoms is then introduced into the chamber. An inert gas, such as argon, is generally used as the gas because it will not react with most materials.

By applying a suitable negative voltage potential between the sputter target and the sputter gun, electrons will be emitted from the casing of the gun, creating a glow discharge. With a proper voltage potential and gas partial pressure, the gas will become ionized from collisions with the emitted electrons, and a plasma will be formed. The ionized gas ions will be positively charged, and will therefore be strongly attracted to the target which is negatively charged. The gas ions are accelerated into the target, and target material is sputtered from the target by momentum transfer. Additionally, the impact of the ions into the target also releases more electrons which are available to further ionize the gas. The material released from the target creates a material vapor which condenses on a smooth surface of the substrate. This process is continued until a coating of a suitable thickness has been formed on the substrate.

In order to increase or concentrate the number of electrons that are available to ionize the gas, it has heretofore been known to create magnetic fields around the sputter gun and target. The magnetic field define a magnetic field trap to help confine the electrons and create an electron cloud around the target. More electrons in the electron cloud means more electrons available to ionize the gas atoms, and more ions to release more material from the target, and thus build up the coating faster. Given the proper trapping of electrons at the target, an avalanche condition will be achieved causing a constant plasma occurring at relatively low voltage potentials, and a low partial pressures of the gas. Therefore, the intent of the known use of the magnetic fields is to provide for a maximum rate of deposition of the sputter material on to the substrate.

Although the known sputtering processes do provide a coating having a smooth surface on the substrate, the resulting coating is relatively uneven on an atomic level, and has a number of defects and the like that act to scatter light. Therefore, the smoothness of the coating can be improved upon to further reduce the amount of scattering of light off of the coating.

It has been discovered that one of the factors contributing to the unevenness of the coating during the sputtering process has to do with the manner in which the target material is released from the target. Apparently, the use of magnetic fields in the known sputtering systems does not create a uniform electron cloud around the target. The non-uniformity of the electron cloud causes more target material to be released from some areas of the target than from other areas. Because of this circumstance, the target material does not condense on the substrate evenly. The growth of the coating on the substrate follows the angle of deposition, and creates an unevenness in the build-up of the target material across the substrate. This non-uniformity of the thickness of the coating increases the scattering of light from the coating in the final product.

What is needed is a sputtering technique that allows for a more uniform growth of the coating on the substrate. It is therefore an object of the present invention to provide such a technique.

### SUMMARY OF THE INVENTION

In accordance with the teachings of the present invention, a sputtering system is disclosed in which one or more electromagnets are used to define a controlled magnetic field that traps an electron cloud around a sputter target. In one particular embodiment, the electromagnets are positioned within a metal casing of a sputter gun associated with the sputtering system. A cylindrical center north pole piece is positioned within a first electromagnetic coil, where the north pole piece is removable. A second electromagnetic coil is wrapped around a cylindrical pole piece spaced apart from the first electromagnetic coil. A third outside electromagnetic coil is wrapped around a cylindrical south pole piece that is spaced apart from the second electromagnetic coil. By controlling the voltage potential applied to each of the three electromagnetic coils, and inserting or removing the center pole piece, the magnetic field around the target can be manipulated.

Additional objects, advantages and features of the present invention will become apparent from the following description and appended claims, taken in conjunction with the accompanying drawings.

### BRIEF DESCRIPTION OF THE DRAWINGS

Figure 1 is a plan view of a magnetron sputter deposition system according to an embodiment of the present invention;
Figure 2 is a cut-away side plan view of a known sputter gun for a magnetron sputter deposition system;
Figure 3 is a graph of magnetic field strength on the vertical axis and location on a target on the horizontal axis showing magnetic field strength relative to a sputter target generated by the known sputter gun of Figure 2;
Figure 4 is a broken-away perspective view of a sputter gun for the sputter deposition system in Figure 1, according to an embodiment of the present invention;
Figure 5 is a cut-away side plan view of the sputter gun shown in Figure 4;
Figure 6 is a power source for applying power to the various electromagnets of the sputter gun shown in Figure 4; and
Figure 7 is a graph of magnetic field strength on the vertical axis and location on a target on the horizontal axis showing magnetic field strength relative to a sputter target for the sputter gun of the invention.

### DETAILED DESCRIPTION OF THE PREFERRED EMBODIMENTS

The following description of the preferred embodiments directed to a magnetron sputter deposition system is merely exemplary in nature, and is in no way intended to limit the invention or its applications or uses.

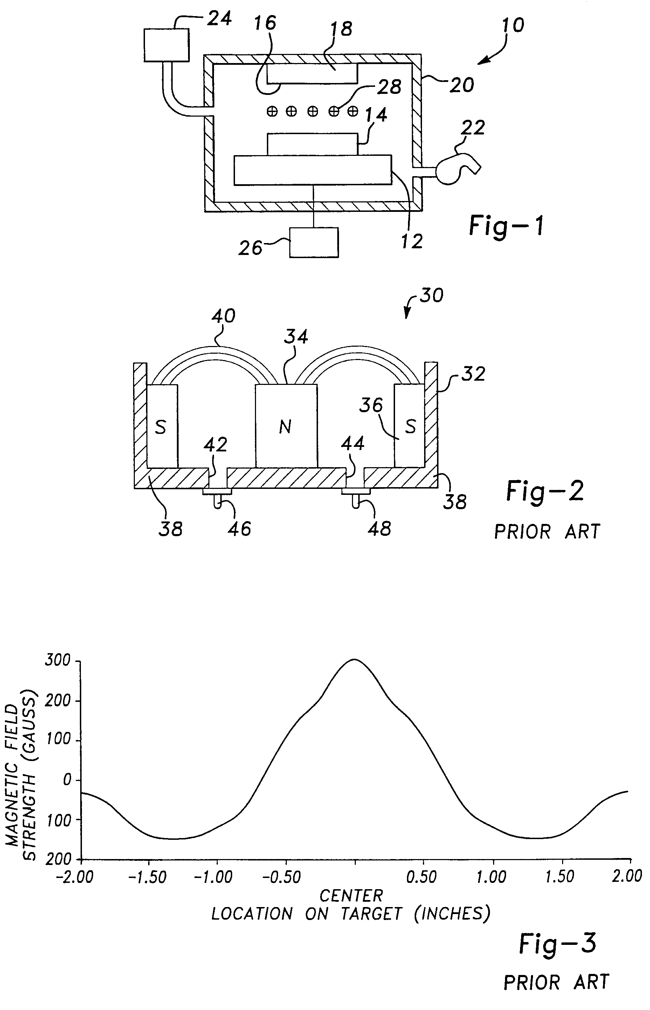

Figure 1 shows a plan view of a magnetron sputter deposition system 10 according to an embodiment of the present invention. The system 10 includes a sputter gun 12 and a sputter target 14 or cathode, such as an aluminum block. Of course, other known sputter targets made of other sputter materials can be used. The sputter gun 12 and the sputter target 14 are electrically isolated from each other. Target material in the form of aluminum atoms is sputtered from the target 14 to coat a surface 16 of a substrate 18 facing the target 14, so that the substrate 18 develops a smooth outer layer of a highly reflective material to a desired thickness.

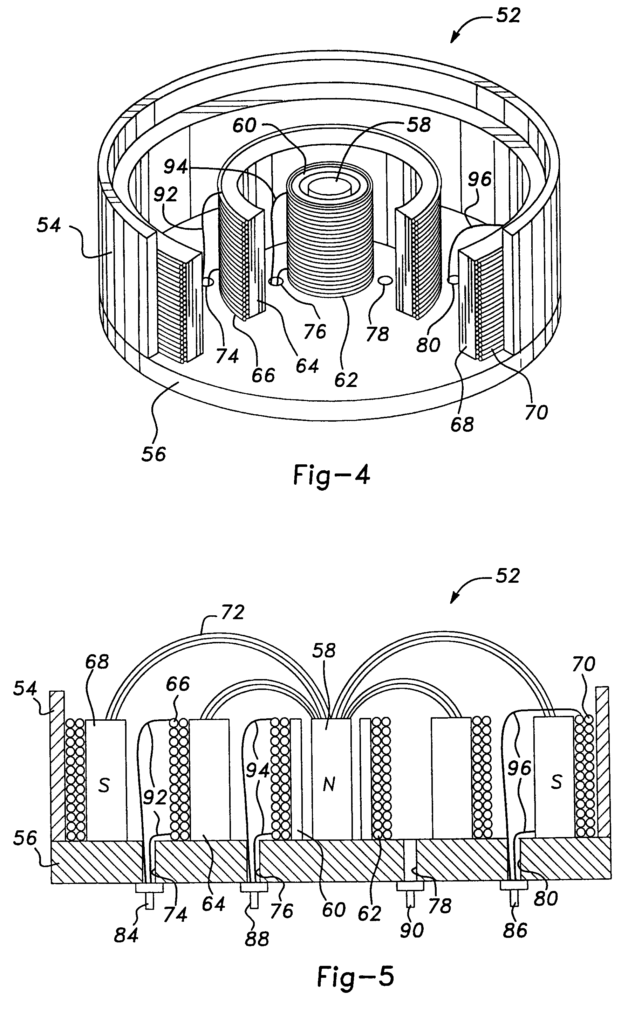

The sputter gun 12, the target 14 and the substrate 18 are positioned relative to each other, as shown, within a vacuum chamber 20. The vacuum chamber 20 is evacuated to a pressure of about 5 x 10⁻⁷ torr by a vacuum pump 22. After the chamber 20 is evacuated, a suitable gas, such as an argon gas, is introduced into the chamber 20 from a gas source 24. The gas source 24 maintains the gas in the chamber 18 at a suitable partial pressure. A high negative voltage potential is applied between the sputter gun 12 and the target 14 by a voltage source 26, such that a glow discharge of electrons are emitted from a metal casing (see Figure 5) of the sputter gun 12. The electrons interact with the gas to ionize the gas and create a gas plasma of ionized gas ions 28. The ionized gas ions 28 will have a positive charge, and therefore will be strongly attracted to the negatively charged target 14. The gas ions 28 are accelerated into the target 14, and target material is sputtered from the target 14 by momentum transfer. A material vapor of the target material is formed in the chamber 20 which then condenses on the surface 16 of the substrate 18. This process is continued until a layer of an appropriate thickness of target material is deposited.

Figure 2 shows a cross-sectional view of a known sputter gun 30 which is suitable to be used as the sputter gun 12, described above. The sputter gun 30 includes a metal casing 32 from which the original electrons are emitted to create the flow discharge of electrons and begin the ionization process. As discussed above, it has heretofore been realized that it is advantageous to create a suitable magnetic field so as to generate an electron trap that traps electrons around the target 14, and increases the ionization of the gas. When the gas ions 28 impinge the target 14, electrons are also released from the target 14, and are available to increase the ionization of the gas.

To create the magnetic field, a first cylindrical permanent north magnetic pole piece 34 and a second permanent south magnetic pole piece 36 are positioned within the casing 32. The north magnetic pole piece 34 is a solid cylindrical pole piece and the pole piece 36 is a cylindrical pole piece surrounding the pole piece 34. A base element 38 of the casing 32 magnetically connects the pole pieces 34 and 36 to help create and shape a magnetic field 40, and is generally a circular plate piece. The strength and position of the magnetic pole pieces 34 and 36 are selected to create the magnetic field 40 suitable to provide a maximum electron cloud adjacent to the target 14 to provide the maximum rate of deposition of the sputter material onto the substrate 18.

An opening 42 is formed through the base element 38 on one side of the pole piece 34, and an opening 44 is formed through the base element 38 at an opposite side of the pole piece 34. A feed line hose 46 is connected to the opening 42 and a return line hose 48 is connected to the opening 44. A cooling fluid, such as water, is introduced through the opening 42 by the feed line hose 46 from a reservoir (not shown), and is returned to the reservoir through the opening 44 and the return line hose 48 such that the cooling fluid circulates around the pole piece 34 within the pole piece 36 to cool the sputter gun 30 during operation.

As discussed above, there is a problem in that the known magnetron sputter deposition systems do not deposit an even layer of the target material onto the substrate. Analysis of the magnetic field created by the permanent magnetic pole pieces 34 and 36 relative to the target 14 shows that the magnetic field strength is different at different locations. Figure 3 shows a graph depicting magnetic field strength on the vertical axis and location on a target, such as the target 14, on the horizontal axis. The location on the target is along one degree of freedom relative to a center of the target. As is apparent, the magnetic field strength created by the magnetic field lines 40 is greater at the center of the target, and tapers off considerably farther away from the center of the target. Thus, for the sputter gun 30, there are more ions available to emit more material from the center area of the target than at surrounding edges.

In order to improve the deposition uniformity of the sputtered material onto the substrate 18, this invention proposes utilizing variable controlled electromagnets in the sputter gun 12 to tailor the magnetic field developed around the target 14. Figure 4 shows a broken-away perspective view and Figure 5 shows a cross-sectional side view of a sputter gun 52 that could be used as the sputter gun 12, discussed above. The sputter gun 52 includes a metal casing defined by a cylindrical shaped side wall 54 and a circular base element 56. A cylindrical permanent north pole magnetic piece 58 is positioned at the center of the sputter gun 52 within the casing, and is removable to generate magnetic fields of varying field strengths for different applications. A non-magnetic cylinder 60 surrounds the magnetic pole piece 58. A first electromagnetic coil 62 is wound around an outside surface of the non-magnetic cylinder 60. Spaced apart from the first electromagnetic coil 62 is a cylindrical pole piece 64, that is made of iron in one embodiment. Other materials besides iron may be suitable. Wrapped around an outside surface of the pole piece 64 opposite to the first electromagnetic coil 62 is a second electromagnetic coil 66. Spaced apart from the second electromagnetic coil 66 is a cylindrical south permanent magnetic pole piece 68. Wrapped around the south pole piece 68 is a third electromagnetic coil 70. In the embodiment shown herein, the electromagnetic coils 62, 66 and 70 are wound such that there is a two coil overlap, as shown. However, other layers of coils are applicable within the scope of the present invention. The combination of the permanent magnets and electromagnets discussed above create magnetic field lines 72 whose position and field strength can be changed by removing or inserting the north pole piece 56, and adjusting the voltage potentials on the electromagnetic coils 62, 66 and 70.

Openings 74, 76, 78 and 80 are formed through the base element 56. A feed line 84 is connected to the opening 74 and a return line 86 is connected to the opening 80. Likewise, a feed line 88 is connected to the opening 76, and a return line 90 is connected to the opening 78. The feed and return lines 84 and 86 allow cooling fluid to circulate between the south pole piece 68 and the coil 66, and the feed and return lines 88 and 90 allow cooling fluid to circulate between the pole piece 64 and the electromagnetic coil 62. Wires 92 are threaded through the opening 74 to provide power to the electromagnetic coil 64, wires 94 are threaded through the opening 76 to provide power to the electromagnetic coil 60, and wires 96 are threaded through the opening 80 to provide power to the electromagnetic coil 68.

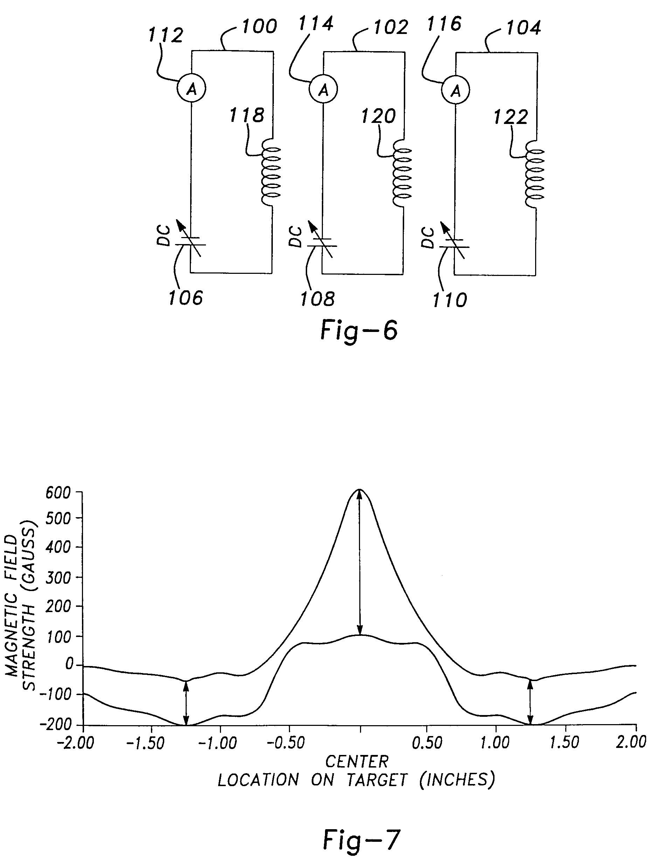

Figure 6 shows three power circuits 100, 102 and 104. The circuits 100, 102 and 104 include a variable DC power source 106, 108 and 110, and a current sensing device 112, 114 and 116, respectively. A coil 118 represents the coil 62, a coil 120 represents the coil 66, and a coil 122 represents the coil 70. By adjusting the voltage on the DC power sources 106, 108 and 110, the magnetic field strength of the electromagnets 62, 66 and 68 can be controlled to define the magnetic field relative to the target 14. The electromagnetic coils 62, 66 and 70 can be either north or south depending on the direction of the current flowing through the coils. If the current is applied in the same direction as the permanent magnet pieces 56 and 68, an increase in field strength is realized, if the current is applied in an opposite direction then the magnetic field strength decreases.

Figure 7 is a graph of magnetic field strength on the vertical axis and location on the target on the horizontal axis to show how the magnetic field strength relative to the target can be changed for a particular location in accordance with the teaching of the invention. As is apparent, the magnetic field strength relative to the target 14 can be adjusted in the manner as described above to adjust the quantity of electrons that are trapped relative to the target 14.

The foregoing discussion discloses and describes merely exemplary embodiments of the present invention. One skilled in the art will readily recognize from such discussion, and from the accompanying drawings and claims, that various changes, modifications and variations can be made therein without departing from the spirit and scope of the invention as defined in the following claims.

## Claims

1. A sputtering system for sputtering a coating onto a substrate, said system comprising:
a chamber;
a substrate positioned within the chamber;
a target positioned relative to the substrate within the chamber;
a sputter gun positioned relative to the target, said sputter gun including a metal casing; and
at least one electromagnetic coil that creates a magnetic field about the target, said at least one electromagnetic coil being controllable so as to control the strength of the magnetic field.

2. The sputtering system according to Claim **1** wherein the metal casing of the sputter gun is a cylindrical casing and wherein the at least one electromagnetic coil is wrapped around a magnetic coil piece within the casing.

3. The sputtering system according to Claim **1** further comprising a pole piece positioned within the at least one electromagnetic coil, said center pole piece being a permanent magnet pole piece that is removable.

4. The sputtering system according to Claim **1** wherein the at least one electromagnetic coil is a first and second electromagnetic coil, said first electromagnetic coil being wrapped around a center cylindrical pole piece and said second electromagnetic coil being wrapped around an outside cylindrical pole piece, said first electromagnetic coil and said center pole piece being positioned within the outside pole piece.

5. The sputtering system according to Claim **4** wherein the center pole piece is a north pole permanent magnet and the outside pole piece is a south pole permanent magnet.

6. The sputtering system according to Claim **1** wherein the at least one electromagnetic coil is three electromagnetic coils, wherein a first electromagnetic coil is wrapped around a cylindrical center pole piece, a second electromagnetic coil is wrapped around an intermediate cylindrical pole piece and a third electromagnetic coil is wrapped around an outside cylindrical pole piece, wherein the center pole piece and the first electromagnetic coil are positioned within the intermediate pole piece and the intermediate pole piece and the second electromagnetic coil are positioned within the outside pole piece.

7. The sputtering system according to Claim **6** wherein the intermediate pole piece is an iron pole piece.

8. The sputtering system according to Claim **1** wherein the metal casing has a cylindrical outer wall and a circular base plate.

9. The sputtering system according to Claim **1** wherein the at least one electromagnetic coil includes two layers of wrapped coils.

10. The sputtering system according to Claim **6** further comprising means for circulating a cooling fluid between the outside cylindrical pole piece and the second electromagnetic coil and means for circulating a cooling fluid between the intermediate pole piece and the first electromagnetic coil.

11. A sputtering system for sputtering a coating onto a substrate, said system comprising:
a vacuum chamber;
a substrate positioned within the vacuum chamber;
a target positioned relative to the substrate within the vacuum chamber; and
a sputter gun positioned relative to the target and being electrically isolated from the target, said sputter gun including a cylindrical metal casing, said sputter gun further including a first electromagnetic coil being wrapped around a center cylindrical pole piece positioned substantially at the center of the casing and a second electromagnetic coil being wrapped around an outside cylindrical pole piece, wherein the first electromagnetic coil and the center pole piece are positioned within the outside pole piece.

12. The sputtering system according to Claim **11** wherein the center pole piece is a permanent magnet pole piece that is removable from the sputter gun.

13. The sputtering system according to Claim **11** further comprising a third electromagnetic coil wrapped around an intermediate cylindrical pole piece, wherein the center pole piece and the first electromagnetic coil are positioned within the intermediate pole piece and the intermediate pole piece and the third electromagnetic coil are positioned within the outside pole piece.

14. The sputtering system according to Claim **13** wherein the center pole piece is a north pole permanent magnet, the outside pole piece is a south pole permanent magnet, and the intermediate pole piece is an iron pole piece.

15. The sputtering system according to Claim **11** wherein the first and second electromagnetic coils each include two layers of wrapped coils.

16. The sputtering system according to Claim **13** further comprising means for circulating a cooling fluid between the outside cylindrical pole piece and the third electromagnetic coil and means for circulating a cooling fluid between the intermediate pole piece and the first electromagnetic coil.

17. A method of sputtering a coating onto a substrate, said method comprising the steps of:
providing a substrate within an evacuated chamber;
providing a target positioned relative to the substrate within the chamber;
providing a sputter gun positioned relative to the target within the chamber;
generating a voltage potential between the sputter gun and the target such that a discharge of electrons is emitted from a casing of the sputter gun;
providing at least one electromagnetic coil within the chamber, said at least one electromagnetic coil creating a magnetic field electron trap about the target; and
adjusting a voltage potential applied to the electromagnetic coil so as to control the strength of the magnetic field about the target and the quantity of electrons in the electron trap.

18. The method according to Claim **17** wherein the step of providing at least one electromagnetic coil within the chamber includes the steps of providing a first electromagnetic coil wrapped around a center cylindrical pole piece and a second electromagnetic coil wrapped around an outside cylindrical pole piece within the casing of the sputter gun, wherein the first electromagnetic coil and the center pole piece are positioned within the outside pole piece.

19. The method according to Claim **17** wherein the step of providing at least one electromagnetic coil within the chamber includes the steps of providing a first electromagnetic coil wrapped around a cylindrical center pole piece, a second electromagnetic coil wrapped around an intermediate cylindrical pole piece and a third electromagnetic coil wrapped around an outside cylindrical pole piece, wherein the center pole piece and the first electromagnetic coil are positioned within the intermediate pole piece and the intermediate pole piece and the second electromagnetic coil are positioned within the outside pole piece.

20. The method according to Claim **18** wherein the step of providing a center pole piece includes providing a removable north pole permanent magnet and the step of providing an outside pole piece includes providing a south pole permanent magnet.

21. A sputter gun comprising:
a casing, said casing including a side wall and a base plate;
a first electromagnetic coil wrapped around a center pole piece within the casing; and
a second electromagnetic coil wrapped around an outside pole piece within the casing, said first electromagnetic coil and said center pole piece being positioned within the outside pole piece.

22. The sputter gun according to Claim **21** further comprising a third electromagnetic coil wrapped around an intermediate pole piece, wherein the center pole piece and the first electromagnetic coil are positioned within the intermediate pole piece and the intermediate pole piece and the third electromagnetic coil are positioned within the outside pole piece.

23. The sputter gun according to Claim **22** wherein the side wall of the casing is a cylindrical side wall and the base plate is a circular base plate, and wherein the center pole piece, the intermediate pole piece and the outside pole piece are cylindrical pole pieces.
